# FASCICULE DE BREVET EUROPEEN

(11) **EP 3 303 941 B1**
(45) Date de publication et mention de la délivrance du brevet: **19.08.2020**
(21) Numéro de dépôt: 16733651.0
(22) Date de dépôt: 01.06.2016
(51) Int. Cl.: F24S 25/632, F24S 25/634, F24S 40/80

(54) **PANNEAU ET DISPOSITIFS DE FIXATION ASSOCIÉS**
PANEEL UND ZUGEHÖRIGE BEFESTIGUNGSVORRICHTUNGEN
PANEL AND ASSOCIATED ATTACHMENT DEVICES

(30) Priorité: 01.06.2015 FR 1554926
(43) Date de publication de la demande: 11.04.2018
(73) Titulaire: A Raymond Et Cie, 38000 Grenoble (FR)
(72) Inventeur: CHEVRIER, Jean-Baptiste, 38660 Saint Vincent De Mercuze (FR); LEGALL, Antoine, 38600 Fontaine (FR); PETRI, Richard, 38500 Voiron (FR); TURLOT, Emmanuel, 38000 Grenoble (FR)
(74) Mandataire: IP Trust
(86) Numéro de dépôt international: PCT/FR2016/051302
(87) Numéro de publication internationale: WO 2016/193614

(56) Documents cités:
- US-A1- 2010 059 641
- US-A1- 2012 090 176
- US-A1- 2013 000 689
- US-B1- 8 522 490
- DATABASE WPI Section EI, Week 201403 Thomson Scientific, London, GB; Class U12, AN 2013-S97836 XP002755939, -& CN 103 187 464 A (DU PONT APOLLO LTD) 3 juillet 2013 (2013-07-03)

## Description

### DOMAINE DE L'INVENTION

La présente invention concerne le domaine des panneaux de grandes dimensions et des dispositifs de fixation associés. Elle concerne en particulier les dispositifs de fixation de modules solaires, et notamment les modules solaires bifaces sans cadre.

### ARRIERE PLAN TECHNOLOGIQUE DE L'INVENTION

Actuellement, plus de 90% des modules photovoltaïques (PV) comprennent un cadre métallique en aluminium permettant de rigidifier les modules fabriqués à partir d'un assemblage d'une plaque de verre en face avant (exposée au soleil) et d'une feuille de matière plastique (Tedlar) en face arrière. Cette configuration permet au module de résister aux fortes sollicitations, exercées par exemple par la neige ou le vent. Un autre avantage d'un tel cadre métallique est de faciliter la fixation mécanique du module PV sur une structure porteuse (métallique ou toiture).

La rigidité mécanique apportée par le cadre permet à cette construction de passer les tests de certification exigés par les normes en vigueur, qui comportent notamment un test sous charge pondérale sévère (5400 Pascals soit 860 kilogrammes sur un module de 250 Watts) qui correspond à une hauteur de neige de plus de 5 mètres. Sous une telle charge, la paroi de verre d'un module cadré de 1 x 1,6 m² fléchit au centre de plus de 100mm.

Si cette structure de module cadré a largement été adoptée, elle présente néanmoins des inconvénients. En particulier, un surcoût de plus de 10% est imposé par la présence du cadre métallique.

Or, l'industrie PV concentre ses efforts de développements à réduire le coût de la production d'électricité tout en améliorant la fiabilité de ses installations.

Les fabricants de modules PV se sont ainsi intéressés, à la construction de modules bi-verres et/ou bifaces sans cadre afin de :
- réduire le coût de fabrication du module en supprimant le cadre ; les modules à base d'un assemblage d'une plaque de verre en face avant et d'une plaque de verre en face arrière sont les plus adaptés à une configuration sans cadre du fait de leur rigidité.
- augmenter la puissance électrique du module sans augmenter sa surface grâce à l'emploi de cellules bifaces.

On trouve dans l'art antérieur deux types de fixations latérales pour modules photovoltaïques sans cadre.

Le premier utilise un ensemble de brides vissées, ou de brides élastiques, avec interposition d'un matériau plastique entre la bride et le module. Par exemple, le document US2013/0000689 divulgue un appareil adapté au support et à la fixation de module sans cadre. Il met en œuvre des éléments de fixation en U comportant une partie métallique et une partie en élastomère en contact avec le module. Le document US8522490 et le document US2012/0090176 proposent quant à eux un élément de fixation permettant un degré de liberté en rotation au module, notamment lors du fléchissement de celui-ci ; cela accroit la résistance du module aux efforts résultant d'une forte charge pondérale, en évitant la concentration de contraintes présentes au niveau des bords des fixations rigides.

L'inconvénient principal de ce type de fixation reste néanmoins la dégradation que subissent les parties en élastomère des éléments de fixation, notamment compte tenu des conditions climatiques sévères auxquelles sont exposés les modules et compte tenu des sollicitations mécaniques subies lors du fléchissement des modules. La fiabilité de maintien des modules s'en trouve dégradée : lors d'un effort important, résultant d'une forte charge pondérale, les bords des modules risquent de s'extraire de l'élément de fixation, provoquant ainsi un endommagement du module PV. C'est particulièrement le cas, lorsque les parties en élastomère sont dégradées au cours du temps.

Le second type de fixation est basé sur le collage d'éléments de fixation directement sur le verre. Par exemple, le document US8720131 divulgue un système de montage de modules PV comportant deux éléments destinés à coopérer l'un avec l'autre pour fixer le module ; l'un des éléments étant collé sur la face arrière du module PV, l'autre élément étant solidaire de rails sur la structure porteuse. Les deux éléments sont aptes à s'emboiter l'un dans l'autre pour permettre la fixation du module. Le document US2010/059641 propose également un système de montage fixé au module PV.

L'inconvénient majeur de ce type de fixation réside dans l'ombrage généré au niveau de la face arrière du module, ce qui est dommageable à la performance d'un module biface. Un autre inconvénient est le faible degré de fléchissement possible du module.

### OBJET DE L'INVENTION

Un objet de l'invention est donc de proposer un système de fixation obviant les inconvénients de l'art antérieur. Un objet de l'invention est notamment un système de fixation d'un panneau, fiable, simple de fabrication et de mise en œuvre et compatible avec des panneaux bifaces.

### BREVE DESCRIPTION DE L'INVENTION

L'invention concerne un panneau susceptible de fléchir sous l'effet d'une charge et présentant une surface périphérique munie d'une pluralité de dispositifs de fixation pivotants ; chaque dispositif de fixation comprend :
- une talonnette métallique collée sur la surface périphérique du panneau ;
- un clip métallique coopérant par emboîtement avec la talonnette et configuré pour autoriser le pivotement de la talonnette lors du fléchissement du panneau;
- au moins une languette de fixation flexible, située entre la talonnette et le clip dans un espace d'emboîtement, et permettant de maintenir la talonnette et le clip l'un par rapport à l'autre; et dans lequel:
- le clip comprend deux parois en vis-à-vis définissant l'espace d'emboîtement permettant d'introduire la talonnette dans le clip selon un axe d'emboîtement (A), ou
- la talonnette comprend deux parois en vis-à-vis définissant l'espace d'emboîtement permettant d'introduire le clip dans la talonnette selon un axe d'emboîtement (A').

Le panneau selon l'invention est muni de dispositifs de fixation métalliques fiables, ne craignant pas de dégradation au cours du temps. Le système de fixation par clip procure une tenue mécanique performante et dont la mise en œuvre est simple. La liaison entre la talonnette et le clip autorisant un mouvement de pivotement de l'un par rapport à l'autre, la résistance du module aux efforts résultant d'une forte charge pondérale est accrue : en effet, lors du fléchissement du panneau, la talonnette collée sur ce dernier est apte à pivoter vis-à-vis du clip, ce qui limite une concentration de contraintes apparaissant typiquement au niveau des bords des fixations rigides.

Par ailleurs, les dispositifs de fixation sont placés sur la surface périphérique du panneau, ce qui les rend compatibles avec des panneaux fonctionnalisés sur les deux faces.

Selon des caractéristiques avantageuses de l'invention, prises seules ou en combinaison :
- la talonnette et le clip sont maintenus l'un par rapport à l'autre par griffure ;
- l'espace d'emboîtement est suffisant pour dégager un espace libre entre la talonnette et le clip, autorisant le pivotement de l'un par rapport à l'autre lors du fléchissement du panneau ;
- chaque dispositif de fixation est configuré pour permettre un mouvement de translation limité de la talonnette selon l'axe d'emboîtement lors du fléchissement du panneau ;
- le panneau présente deux faces principales et un bord reliant les deux faces principales, et la surface périphérique s'étend sur une partie périphérique de chacune des faces principales et sur le bord ;
- chaque dispositif de fixation comprend une butée bloquant le mouvement en translation de la talonnette, selon une direction perpendiculaire à l'axe d'emboîtement et parallèle aux faces principales du panneau ;
- la talonnette comprend une première partie collée sur une des faces principales ;
- la talonnette comprend une deuxième partie collée sur l'autre des faces principales ;
- la talonnette comprend une troisième partie collée sur le bord, formant avec les première et deuxième parties une cornière en U ;
- la talonnette comporte une partie déportée présentant deux faces opposées et libres sur lesquelles le clip est fixé ;
- le dispositif de fixation comprend un corps d'appui linéaire contribuant à autoriser le pivotement de la talonnette lors du fléchissement du panneau.

Le dispositif de fixation selon l'invention autorise un mouvement de pivotement entre la talonnette et le clip, ainsi qu'un mouvement de translation limité selon l'axe d'emboîtement. Ces degrés de liberté de mouvement permettent d'accompagner le panneau lors de son fléchissement et limitent les points de concentration de contraintes. Le dispositif de fixation selon l'invention bloque le mouvement de translation selon l'axe perpendiculaire à l'axe d'emboîtement, dans le plan des faces principales du panneau : cela prévient tout endommagement des bords des panneaux par contact et/ou frottement entre deux panneaux voisins.

Selon une approche avantageuse, le clip porte au moins une languette de fixation formée par découpe et pliage, griffée sur la talonnette. La dureté du matériau constituant le clip est supérieure à celle du matériau constituant la talonnette, de manière à assurer le maintien du panneau par griffure de la languette de fixation sur la talonnette. A titre d'exemple, la talonnette est en aluminium et le clip est en acier.

Selon une autre approche avantageuse, la talonnette porte au moins une languette de fixation formée par découpe et pliage, griffée sur le clip. La dureté du matériau constituant la talonnette est supérieure à celle du matériau constituant le clip, de manière à assurer le maintien du panneau par griffure de la languette de fixation sur le clip. A titre d'exemple, le clip est en aluminium et la talonnette est en acier.

Selon encore une autre approche avantageuse, chaque dispositif de fixation comprend au moins une agrafe positionnée dans l'espace d'emboîtement entre la talonnette et le clip, l'agrafe portant une pluralité de languettes de fixation formées par découpe et pliage. La dureté du matériau constituant l'agrafe est supérieure à celle des matériaux constituant le clip et la talonnette, de manière à assurer le maintien du panneau par griffure des languettes de fixation sur le clip et sur la talonnette. A titre d'exemple, le clip et la talonnette sont en aluminium et l'agrafe est en acier.

Selon d'autres caractéristiques avantageuses de l'invention, prises seules ou en combinaison :
- le panneau constitue un module photovoltaïque comportant une pluralité de cellules photovoltaïques ;
- la partie périphérique des faces principales du panneau est une zone dite morte, dépourvue de cellules photovoltaïques ;
- le module photovoltaïque est un module photovoltaïque bi-verre sans cadre ;
- le module photovoltaïque est un module photovoltaïque biface sans cadre
- chaque dispositif de fixation comporte un élément support solidaire du clip pour assembler le panneau sur une structure porteuse ;

L'invention concerne en outre un assemblage de panneaux comportant :
- une structure porteuse présentant des rails de maintien
- une pluralité de panneaux reposant sur les rails par l'intermédiaire des éléments supports ;
- des moyens de fixation pour assembler les éléments supports sur les rails.

### BREVE DESCRIPTION DES DESSINS

D'autres caractéristiques et avantages de l'invention ressortiront de la description détaillée de l'invention qui va suivre en référence aux figures annexées sur lesquelles :
- la figure 1 présente une vue en coupe d'un panneau muni d'un dispositif de fixation, selon un premier mode de réalisation de l'invention ;
- la figure 2 présente une vue en coupe d'un panneau muni d'un dispositif de fixation, selon un deuxième mode de réalisation de l'invention ;
- les figures 3 et 4 présentent des vues en coupe d'un panneau muni d'un dispositif de fixation, selon des variantes des premiers et deuxièmes modes de réalisation de l'invention ;
- la figure 5 présente une vue en coupe d'un panneau muni d'un dispositif de fixation, selon un troisième mode de réalisation de l'invention ;
- la figure 6 présente une vue en coupe d'un panneau muni d'un dispositif de fixation, selon un quatrième mode de réalisation de l'invention ;
- la figure 7 présente une vue en coupe d'un panneau muni d'un dispositif de fixation, selon un cinquième mode de réalisation de l'invention ;
- la figure 8 présente une vue en perspective d'un panneau muni d'un dispositif de fixation selon une variante du cinquième mode de réalisation de l'invention ;
- la figure 9 présente une vue en coupe d'un panneau muni d'un dispositif de fixation, selon un sixième mode de réalisation de l'invention ;
- la figure 10 présente une vue en perspective d'un panneau muni d'un dispositif de fixation selon une variante du sixième mode de réalisation de l'invention ;
- la figure 11 présente une vue en coupe d'un assemblage de panneaux, conforme à l'invention ;
- la figure 12 présente une vue de dessus d'un assemblage de panneaux, conforme à l'invention ;
- la figure 13 présente une vue en coupe d'un panneau muni d'une pluralité de dispositifs de fixation, conforme à l'invention.

### DESCRIPTION DETAILLEE DE L'INVENTION

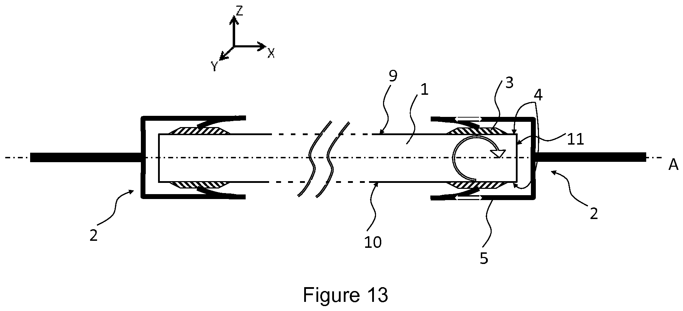

L'invention concerne un panneau 1 susceptible de fléchir sous l'effet d'une charge et présentant une surface périphérique 4 munie d'une pluralité de dispositifs de fixation 2 pivotants, illustré en figure 13.

Le panneau 1 est constitué de deux faces principales 9,10 et un bord 11 sur toute sa périphérie, reliant les deux faces principales 9,10. On définit par surface périphérique 4, une surface qui s'étend sur une partie périphérique de chacune des faces principales 9,10 et sur le bord 11. Typiquement, le panneau 1 est de forme parallélépipédique, avec sa largeur selon l'axe X (schématisé sur la figure 13), sa longueur selon l'axe Y et son épaisseur selon l'axe Z.

Selon l'invention, chaque dispositif de fixation comprend :
- une talonnette 3 métallique collée sur la surface périphérique 4 du panneau 1 ;
- un clip métallique 5 coopérant par emboîtement avec la talonnette 3 et configuré pour autoriser le pivotement de la talonnette 3 lors du fléchissement du panneau 1.

La talonnette 3 et le clip 5, tous deux métalliques, sont avantageusement maintenus l'un par rapport à l'autre par griffure : c'est-à-dire qu'un élément pouvant être compris dans la talonnette 3, le clip 5 ou un corps supplémentaire, est griffé respectivement sur le clip 5, la talonnette 3 ou les deux, selon différents modes de réalisation qui seront décrits en détail plus avant. Ce contact par griffure assure un bon maintien mécanique entre la talonnette 3 et la clip 5, tout en autorisant le pivotement de la talonnette 3 dans le clip 5 lors du fléchissement du panneau 1.

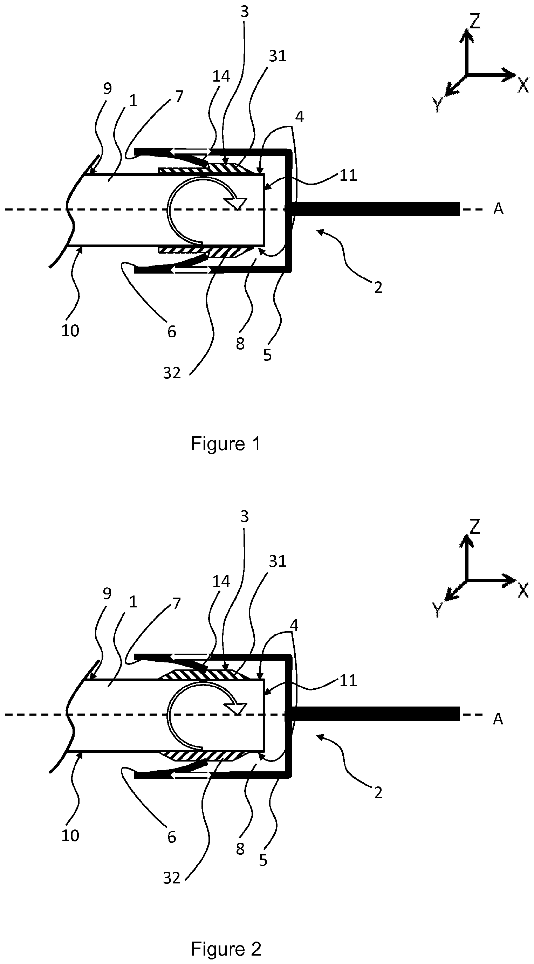

Selon un premier mode de réalisation présenté en figure 1, la talonnette 3 est constituée de deux parties 31,32, respectivement collées sur une partie périphérique des deux faces principales 9,10 du panneau 1. La talonnette 3 est constituée d'un matériau métallique et est collée sur le panneau 1 grâce à une substance adhésive permettant une forte adhérence entre des surfaces métal/verre ou métal/polymère, choisie parmi les colles silicone, époxyde, polyuréthane...
A titre d'exemple, les dimensions de chacune des parties 31,32 de la talonnette 3 se décomposent en :
- une longueur (selon l'axe Y schématisé sur la figure 1) comprise entre 50 et 100mm, avantageusement égale à 80mm ;
- une largeur (selon l'axe X schématisé sur la figure 1) comprise entre 10 et 20mm, avantageusement égale à 15mm ;
- une épaisseur (selon l'axe Z schématisé sur la figure 1) comprise entre 2 et 4mm, avantageusement égale à 3mm.
Chaque partie de la talonnette 3 comporte un épaulement de l'ordre de 0,1-0,5mm, schématisé sur la figure 1, qui permettra de bloquer le clip 5 après son emboîtement sur la talonnette 3.

Le clip 5 métallique comprend au moins deux parois 6,7 définissant un espace d'emboîtement 8, permettant d'introduire la talonnette 3 dans le clip 5 selon un axe d'emboîtement A. Les deux parois 6,7 du clip 5 ont des dimensions en longueur (selon l'axe Y schématisé sur la figure 1) comprises entre 50 et 100mm et en largeur (selon l'axe X schématisé sur la figure 1), comprises entre 10 et 20mm. L'épaisseur des parois 6,7 peut varier entre 1 et 3mm.

Le clip 5 comporte en outre des languettes 14 flexibles, avantageusement réalisées par découpe et pliage d'une partie de chacune de ses deux parois 6,7. Les languettes 14 sont orientées vers l'intérieur de l'espace d'emboîtement 8 et configurées de sorte qu'elles soient flexibles et s'écartent lorsque le panneau 1 muni de la talonnette 3 est introduit dans le clip 5, selon l'axe d'emboîtement A ; elles n'opposent donc pas de résistance à l'emboîtement de la talonnette 3 dans le clip 5. Elles sont également configurées de sorte qu'elles soient rigides et se bloquent sur l'épaulement de la talonnette 3, lorsque le panneau 1 est tiré dans le sens de l'extraction de l'espace d'emboîtement 8. Le panneau 1 est ainsi solidement maintenu dans chaque dispositif de fixation du fait de la coopération entre la talonnette 3 (collée sur la surface périphérique du panneau 1) et les languettes 14 du clip 5, qui assure une fonction anti-retour. En outre, la liaison mécanique entre les languettes 14 et les deux parties 31,32 de la talonnette 3 sollicite l'interface de collage talonnette/panneau essentiellement en cisaillement : les colles choisies pour fixer la talonnette 3 sur la surface périphérique 4 du panneau 1 offrent justement une très forte résistance à ce type de contraintes.

Selon ce premier mode de réalisation de l'invention, le clip 5 enserre les deux parties 31,32 de la talonnette 3 et une partie périphérique du panneau 1. Le panneau 1 a néanmoins des degrés de liberté de mouvement : en pivotement d'une part, comme schématisé par la flèche en arc de cercle sur la figure 1. Ce mouvement permet d'accompagner le fléchissement du panneau 1 et évite de créer un point de concentration de contraintes par contact plan du panneau 1 sur les parois 6,7 du clip 5. Le pivotement est possible du fait d'un espace libre suffisant, ménagé dans l'espace d'emboîtement 8 et du caractère flexible des languettes 14. Cet espace libre évite tout contact entre la talonnette 3 ou le panneau 1 et le clip 5, autre que le contact de maintien assuré par les languettes 14 sur la talonnette 3. L'espacement entre chaque paroi 6,7 du clip 5 et la partie 31,32 de la talonnette 3 en vis-à-vis est de l'ordre de 2-3mm.

D'autre part, le panneau 1 a un degré de liberté de mouvement en translation, selon l'axe d'emboîtement A, comme illustré par les deux flèches blanches sur la figure 1. L'amplitude de ce mouvement de translation est néanmoins limité : il est bloqué dans le sens de l'extraction du panneau 1 par l'épaulement (représenté sur la figure 1) présent sur chaque partie 31,32 de la talonnette 3 ; il est libre sur quelques millimètres (1 à 3mm) dans le sens de l'introduction du panneau 1.

Les degrés de liberté de mouvement en pivotement et en translation selon l'axe d'emboîtement A accroissent la résistance du panneau 1 aux efforts résultant d'une forte charge pondérale. La liaison mécanique entre les deux parties 31,32 de la talonnette 3 métallique et les languettes 14 métalliques du clip 5 est particulièrement résistante et prévient tout endommagement dans le temps du dispositif de fixation ou extraction non intentionnelle du panneau 1.

La figure 2 présente un deuxième mode de réalisation selon l'invention. La talonnette 3 est constituée de deux parties 31,32, collées respectivement sur une partie périphérique des deux faces principales 9,10 du panneau 1. La talonnette 3 est constituée d'un matériau métallique et est collée sur le panneau 1 grâce à une substance adhésive. Chaque partie 31,32 de la talonnette 3 a des dimensions dans les mêmes gammes que celles décrites précédemment dans le premier mode de réalisation.

Le clip 5 métallique comprend au moins deux parois 6,7 définissant un espace d'emboîtement 8, permettant d'introduire la partie périphérique du panneau 1, munie de la talonnette 3, dans le clip 5 selon un axe d'emboîtement A. Il comporte en outre des languettes 14 flexibles, avantageusement réalisées par découpe et pliage d'une partie de chacune de ses deux parois 6,7. Les languettes 14 sont orientées vers l'intérieur de l'espace d'emboîtement 8 et configurées de sorte qu'elles soient flexibles et s'écartent lorsque le panneau 1 muni des talonnettes 3 est introduit dans le clip 5, selon l'axe d'emboîtement A. Elles sont également configurées de sorte qu'elles soient rigides et se griffent dans les parties 31,32 de la talonnette 3, lorsque le panneau 1 est tiré dans le sens de l'extraction de l'espace d'emboîtement 8. La dureté du matériau constituant le clip 5 (et donc les languettes 14) est supérieure à celle du matériau constituant la talonnette 3, de manière à permettre la pénétration et la griffure des languettes 14 dans la talonnette 3. A titre d'exemple, la talonnette 3 est en aluminium et le clip 5 est en acier.

Le panneau 1 est ainsi solidement maintenu dans chaque dispositif de fixation du fait de la coopération entre les deux parties 31,32 de la talonnette 3 (collées sur la surface périphérique du panneau 1) et les languettes 14 du clip 5, qui assure une fonction anti-retour. En outre, la liaison mécanique entre les languettes et les talonnettes sollicite l'interface de collage talonnette/panneau essentiellement en cisaillement : les colles choisies pour fixer chaque talonnette 3 sur la surface périphérique 4 du panneau 1 offrent justement une très forte résistance à ce type de contraintes.

Selon ce deuxième mode de réalisation de l'invention, le clip 5 enserre les deux parties 31,32 de la talonnette 3 et une partie périphérique du panneau 1. Le panneau 1 a néanmoins des degrés de liberté de mouvement : en pivotement d'une part, comme schématisé par la flèche en arc de cercle sur la figure 2. Ce mouvement permet d'accompagner le fléchissement du panneau 1 et évite de créer un point de concentration de contraintes par contact plan du panneau 1 sur les parois 6,7 du clip 5. Le pivotement est possible du fait d'un espace libre suffisant, ménagé dans l'espace d'emboîtement 8 et du caractère flexible des languettes 14. L'espacement entre chaque paroi 6,7 du clip 5 et la partie 31,32 de la talonnette 3 en vis-à-vis est de l'ordre de 2-3mm.

D'autre part, le panneau 1 a un degré de liberté de mouvement en translation, selon l'axe d'emboîtement A, comme illustré par les deux flèches blanches sur la figure 2. L'amplitude de ce mouvement de translation est néanmoins limité. En effet, il est bloqué dans le sens de l'extraction du panneau 1 par un bourrelet (non représenté sur la figure 2) formé sur chaque partie 31,32 de la talonnette 3 par la griffure des languettes 14 : le matériau constitutif des languettes 14, plus dur, griffe la matériau constitutif des parties 31,32 de la talonnettes 3, et forme en bout de griffure un bourrelet sur lesdites parties 31,32 ; ce bourrelet agit comme un épaulement ou une butée et bloque le mouvement de translation, dans le sens de l'extraction du panneau 1. La hauteur du bourrelet est de l'ordre de 0,1mm. Par ailleurs, le panneau 1 garde une liberté de mouvement en translation, sur quelques millimètres (1 à 3mm), dans le sens de l'introduction du panneau 1.

Les degrés de liberté de mouvement en pivotement et en translation selon l'axe d'emboîtement A accroissent la résistance du panneau 1 aux efforts résultant d'une forte charge pondérale. La liaison mécanique entre les parties 31,32 de la talonnette 3 métallique et les languettes 14 métalliques du clip 5 est particulièrement résistante. Le bourrelet formé dans le matériau métallique de la talonnette par déformation plastique constitue un épaulement durable dans le temps assurant le blocage des languettes 14 sur la talonnette 3 et par là même le maintien du panneau 1 dans chaque dispositif de fixation.

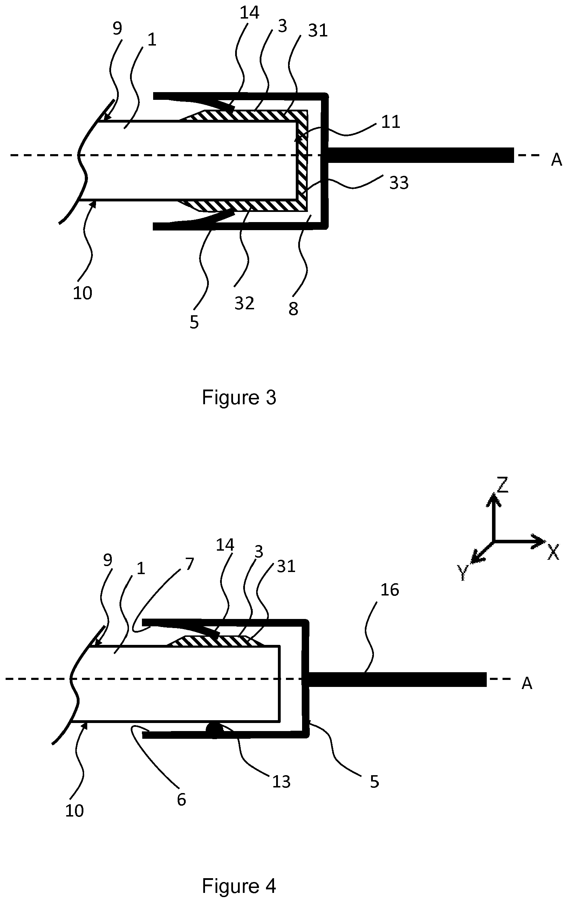

Selon une variante du deuxième mode de réalisation, présentée sur la figure 3, le dispositif de fixation comprend une talonnette 3 constituée de 3 parties : une première partie 31, collée sur la partie périphérique de la première face principale 9 du panneau 1, une deuxième partie 32, collée sur la partie périphérique de la deuxième face principale 10 du panneau 1, et une troisième partie 33, collée sur le bord 11 du panneau 1. Dans ce cas de figure, la talonnette 3 forme une cornière en U collée sur la surface périphérique du panneau 1. Les première 31 et deuxième 32 parties de la talonnette 3 sont destinées à coopérer avec les languettes 14 du clip 5, pour assurer la fixation du panneau 1. La partie 33 de la talonnette 3 apporte quant à elle une protection du bord 11 et des angles entre les faces principales 9,10 et le bord 11 du panneau : elle évite un potentiel contact entre le matériau (par exemple du verre) du panneau 1 et le clip 5 métallique dans l'espace d'emboîtement 8 et un endommagement associé.

Selon une autre variante du deuxième mode de réalisation, le dispositif de fixation comporte une talonnette 3, formée d'une partie 31 collée sur la partie périphérique d'une des faces principales, par exemple la première face principale 9, comme illustré sur la figure 4. La talonnette 3 est destinée à coopérer avec au moins une languette 14, réalisée par découpe et pliage d'une partie de la paroi 7 du clip 5, pour assurer la fixation du panneau 1. Avantageusement, la languette 14 s'étend sur la longueur de la paroi 7, formant ainsi une liaison mécanique linéaire (selon l'axe Y schématisé sur la figure 4) avec la talonnette 3. A titre d'exemple, la talonnette a une longueur de 60mm, le clip (et donc la paroi 7) a une longueur de 60mm et la languette s' étend sur une longueur de 40mm ; elle vient ainsi griffer la talonnette sur une zone linéaire de 40mm et crée un bourrelet sensiblement de cette longueur. La hauteur (selon l'axe Z) du bourrelet est de l'ordre de 0,1mm.

La paroi 6 du clip 5 est quant à elle munie d'un corps d'appui 13 linéaire selon l'axe Y schématisé sur la figure 4, contribuant à autoriser le pivotement de la talonnette 3 lors du fléchissement du panneau 1. Le corps d'appui 13 a par exemple une forme de demi-cylindre de longueur 40mm et ménage un espace entre le panneau 1 et la paroi 6 du clip 5 de l'ordre de 2-3mm. Sur la figure 4, le corps d'appui 13 est formé sur la paroi 6 du clip 5 et est en contact direct avec le panneau. Selon une variante non représentée, le panneau 1 peut comporter une deuxième partie de talonnette 3 sur la partie périphérique de sa deuxième face principale 10 ; le corps d'appui 13 est alors en contact avec la talonnette 3. Selon une autre variante non représentée, le corps d'appui 13, en forme de demi-cylindre peut être collé sur la partie périphérique de la deuxième face principale 10 du panneau 1 ; le corps d'appui 13 est alors en contact avec la paroi 6 du clip 5.

Les variantes décrites ne sont bien sur pas limitées au deuxième mode de réalisation ; elles peuvent être combinées entre elles et/ou appliquées aux différents modes de réalisation selon l'invention.

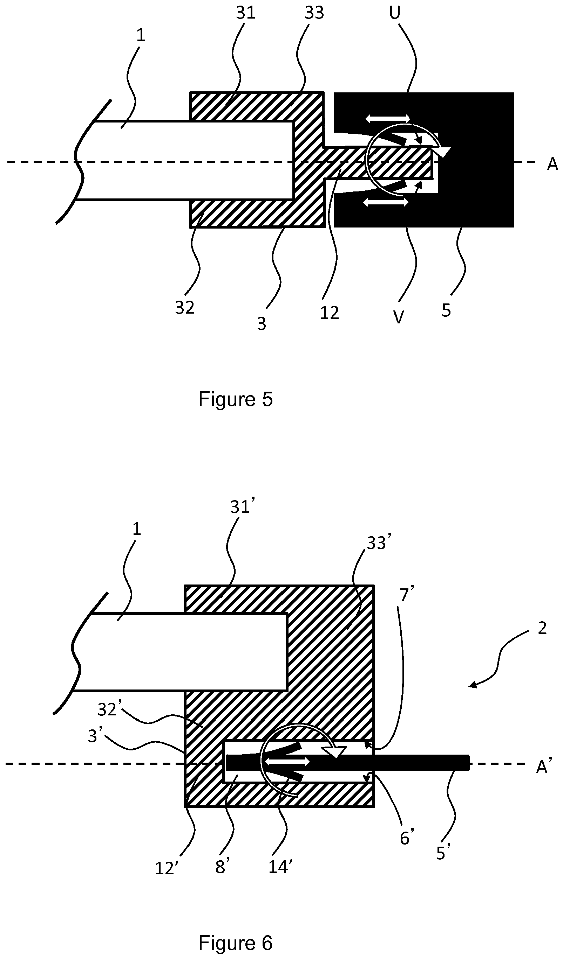

La figure 5 présente un troisième mode de réalisation selon l'invention. La talonnette 3, collée sur la surface périphérique du panneau 1, comporte trois parties 31,32,33 formant une cornière en U. Elle comporte en outre une partie déportée 12 présentant deux faces U,V opposées et libres sur lesquelles le clip 5 est fixé. La fixation est faite grâce à des languettes griffées sur ces deux faces ou bloquées par des épaulements présents sur ces deux faces. Dans ce cas de figure, le clip 5 n'enserre que la partie déportée 12 de la talonnette 3, et non la partie périphérique du panneau 1. La partie déportée 12 de la talonnette 3 a des degrés de liberté de mouvement en pivotement et en translation (limité) tels que représentés par les flèches blanches sur la figure 5. Cela permet d'accompagner le mouvement du panneau 1 lors d'une flexion sous charge pondérale.

La figure 6 présente un quatrième mode de réalisation selon l'invention. La talonnette 3', collée sur la surface périphérique du panneau 1, comporte trois parties 31',32',33' formant une cornière en U et une partie déportée 12'. Cette fois, la partie déportée 12' comprend deux parois 6',7' en vis-à-vis définissant un espace d'emboîtement 8' permettant d'introduire le clip 5' selon un axe d'emboîtement A'.

Le clip 5' comporte des languettes 14' flexibles, avantageusement réalisées par découpe et pliage d'une partie du clip 5'. Les languettes 14' sont configurées de sorte qu'elles soient flexibles et se resserrent lorsque le clip 5' est introduit dans l'espace d'emboîtement 8' de la partie déportée 12' de la talonnette 3', selon l'axe d'emboîtement A' ; elles n'opposent donc pas de résistance à l'emboîtement du clip 5' et de la talonnette 3'. Elles sont également configurées de sorte qu'elles soient rigides et se griffent dans les parois 6',7' de la partie déportée 12' de la talonnette 3', dans le sens de l'extraction du clip 5' de l'espace d'emboîtement 8'. La dureté du matériau constituant le clip 5' (et donc les languettes 14') est supérieure à celle du matériau constituant la talonnette 3', de manière à permettre la pénétration et la griffure des languettes 14' dans la talonnette 3'. A titre d'exemple, la talonnette 3 est en aluminium et le clip 5 est en acier.

De manière alternative, les parois 6',7' de la partie déportée 12' de la talonnette 3' comportent un épaulement permettant de bloquer les languettes dans le sens de l'extraction du clip 5' de l'espace d'emboîtement 8'. Selon cette variante, la talonnette 3' et le clip 5' peuvent être constitués du même matériau.

Le panneau 1 est ainsi solidement maintenu dans chaque dispositif de fixation du fait de la coopération entre chaque talonnette 3' et les languettes 14' de chaque clip 5'. Il conserve néanmoins des degrés de liberté de mouvement en pivotement et en translation (limité), comme expliqué précédemment, du fait du caractère flexible des languettes 14' et de l'espace libre ménagé dans l'espace d'emboîtement 8', entre les parois 6',7' de la partie déportée 12' de la talonnette 3' et le clip 5'.

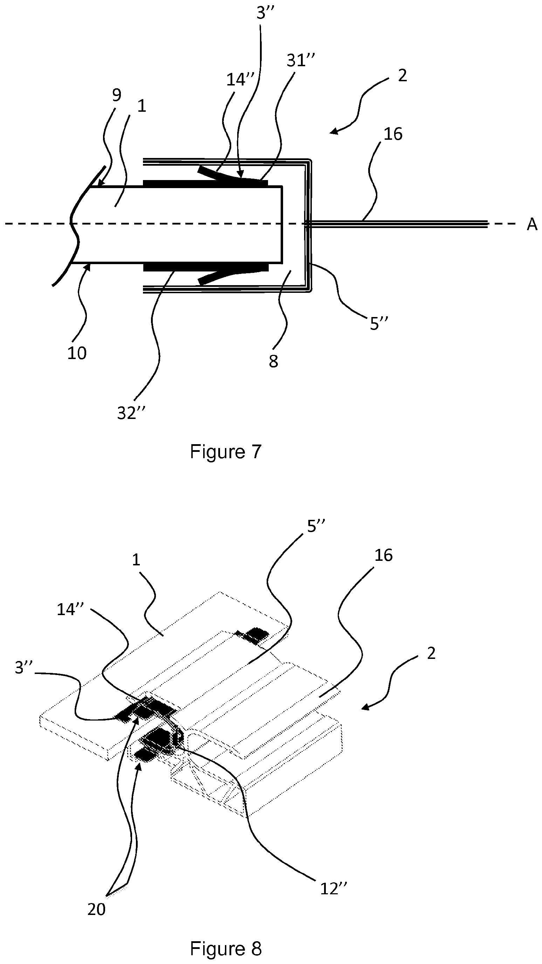

Selon un cinquième mode de réalisation de l'invention, représenté sur la figure 7, la talonnette 3" est constituée de deux parties 31",32", collées sur la partie périphérique respectivement des deux faces principales 9,10 du panneau 1. Chaque partie 31",32" de la talonnette 3" comporte au moins une languette 14" flexible, configurée de sorte qu'elle se resserre lorsque le panneau 1 muni de la talonnette 3" est introduit dans le clip 5", selon l'axe d'emboîtement A ; la languette 14" n'oppose ainsi pas de résistance à l'emboîtement de la talonnette 3" dans le clip 5". Elle est également configurée de sorte qu'elle soit rigide et se griffe dans la paroi interne du clip 5", lorsque le panneau 1 est tiré dans le sens de son extraction de l'espace d'emboîtement 8. La dureté du matériau constituant la talonnette 3" (et donc les languettes 14") est supérieure à celle du matériau constituant la clip 5", de manière à permettre la pénétration et la griffure des languettes 14" dans les parois internes du clip 5". A titre d'exemple, la talonnette 3" est en acier et le clip 5" est en aluminium.

Le panneau 1 est ainsi solidement maintenu dans chaque dispositif de fixation 2 du fait de la coopération entre les languettes 14" des parties 31",32" de la talonnette 3" et les parois internes du clip 5". En outre, la liaison mécanique entre les languettes 14" et le clip 5" sollicite l'interface de collage talonnette/panneau essentiellement en cisaillement : les colles choisies pour fixer chaque talonnette 3" sur la surface périphérique du panneau 1 offrent justement une très forte résistance à ce type de contraintes.

La figure 8 présente une variante du cinquième mode de réalisation selon l'invention. La talonnette 3" comprend deux parties collées sur la partie périphérique des deux faces principales du panneau 1. Elle comprend également une partie déportée 12" en forme de U, qui porte les languettes 14" destinées à coopérer avec le clip 5". Le clip 5" a une forme en U, définissant un espace d'emboîtement destiné à recevoir la partie déportée 12" de la talonnette 3". Les parois intérieures du clip 5", en vis-à-vis avec les languettes 14", comportent des épaulements permettant de bloquer les languettes 14" après introduction de la talonnette 3" dans l'espace d'emboîtement du clip 5" : cette liaison assure la fonction anti-retour (dans le sens de l'extraction du panneau 1) du dispositif de fixation 2.

Afin de faciliter le démontage du dispositif de fixation 2, par exemple pour effectuer un changement de panneau 1, la partie déportée 12" de la talonnette 3" comprend en outre deux ailettes 20 solidaires des languettes 14", en chacune de ses extrémités dans le sens de la longueur. Le rapprochement de deux ailettes 20 en vis-à-vis permet de fléchir les languettes 14" de manière à leur faire franchir l'épaulement du clip 5" et à les débloquer. Ce rapprochement des ailettes deux à deux se fait par application d'une force de serrage sur les deux ailettes. Cette configuration permet donc de désolidariser la talonnette 3 (et donc le panneau 1) du clip 5", sans utilisation d'outils spécifiques, offrant une solution de fixation robuste, simple et efficace.

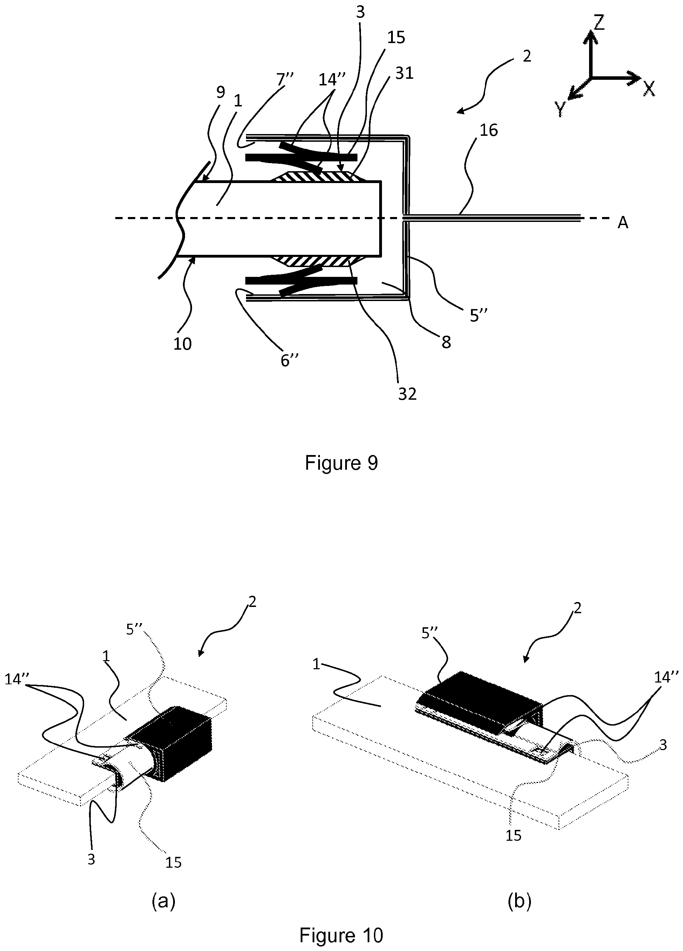

La figure 9 présente un sixième mode de réalisation selon l'invention. La talonnette 3 est constituée de deux parties 31,32, collées sur une partie périphérique respectivement des deux faces principales 9,10 du panneau 1. La talonnette 3 est constituée d'un matériau métallique et est collée sur le panneau 1 grâce à une substance adhésive permettant une forte adhérence entre des surfaces métal/verre ou métal/polymère, choisie parmi les colles silicone, époxyde, polyuréthane...
A titre d'exemple, les dimensions des deux parties 31,32 de la talonnette 3 se décomposent en :
- une longueur (selon l'axe Y schématisé sur la figure 9) comprise entre 50 et 100mm, avantageusement égale à 80mm ;
- une largeur (selon l'axe X schématisé sur la figure 9) comprise entre 10 et 20mm, avantageusement égale à 15mm ;
- une épaisseur (selon l'axe Z schématisé sur la figure 9) comprise entre 2 et 4mm, avantageusement égale à 3mm.

Le clip 5'' métallique comprend au moins deux parois 6",7" définissant un espace d'emboîtement 8, permettant d'introduire les parties 31,32 de la talonnette 3 dans le clip 5" selon un axe d'emboîtement A. Les deux parois 6",7" du clip 5" ont des dimensions en longueur (selon l'axe Y schématisé sur la figure 9) comprises entre 50 et 100mm et en largeur (selon l'axe X schématisé sur la figure 9), comprises entre 10 et 20mm. L'épaisseur des parois 6",7" peut varier entre 1 et 3mm.

Le dispositif de fixation 3 comporte en outre une agrafe 15 métallique ; elle comprend des languettes 14" flexibles, avantageusement réalisées par découpe et pliage d'une partie de l'agrafe 15. Les languettes 14" sont destinées à être griffées d'une part sur chacune des parties 31,32 de la talonnette 3 et d'autre part sur les parois 6",7" internes du clip 5". La dureté du matériau constituant l'agrafe 15 (et donc les languettes 14") est supérieure à celle du matériau constituant la talonnette 3 et le clip 5", de manière à permettre la pénétration et la griffure des languettes 14" dans les parties 31,32 de la talonnette 3. A titre d'exemple, la talonnette 3 et le clip 5'' sont en aluminium et l'agrafe 15 est en acier.

Selon ce sixième mode de réalisation, le clip 5" enserre l'agrafe 15, les deux parties 31,32 de la talonnette 3 et une partie périphérique du panneau 1. Le panneau 1 est ainsi solidement maintenu dans chaque dispositif de fixation du fait de la coopération entre d'une part, les parties 31,32 de la talonnette 3 (collées sur la surface périphérique du panneau 1) et les languettes 14" de l'agrafe 15, et d'autre part les parois 6",7" du clip 5" et les languettes 14" de l'agrafe 15.

Le panneau 1 a néanmoins des degrés de liberté de mouvement : en pivotement d'une part, ce mouvement permettant d'accompagner le fléchissement du panneau 1 et évite de créer un point de concentration de contraintes par contact plan du panneau 1 sur les parois 6",7" du clip 5". Le pivotement est possible du fait d'un espace libre suffisant, ménagé dans l'espace d'emboîtement 8 et du caractère flexible des languettes 14". Cet espace libre évite tout contact entre la talonnette 3 ou le panneau 1 et le clip 5", autre que le contact de maintien assuré par les languettes 14". L'espacement entre chaque paroi 6",7" du clip 5" et l'agrafe 15 est de l'ordre de 2mm ; l'espacement entre l'agrafe 15 et chaque partie 31,32 de la talonnette 3 en vis-à-vis est également de l'ordre de 2mm.

D'autre part, le panneau 1 a un degré de liberté de mouvement en translation, selon l'axe d'emboîtement A. L'amplitude de ce mouvement de translation est néanmoins limité. En effet, il est bloqué dans le sens de l'extraction du panneau 1 par un bourrelet (non représenté sur la figure 9) formé sur chaque partie 31,32 de la talonnette 3 par la griffure des languettes 14" : le matériau constitutif des languettes 14", plus dur, griffe la matériau constitutif de la talonnette 3, et forme en bout de griffure un bourrelet sur les parties 31,32 de la talonnette 3 ; ce bourrelet agit comme un épaulement et bloque le mouvement de translation, dans le sens de l'extraction du panneau 1. De la même manière, un bourrelet (non représenté sur la figure 9) est formé sur les parois 6",7" interne du clip 5", du fait de la griffure des languettes 14" coopérant avec lesdites parois 6",7". La hauteur des bourrelets est de l'ordre de 0,1mm. Par ailleurs, le panneau 1 garde une liberté de mouvement en translation, sur quelques millimètres (1 à 3mm), dans le sens de l'introduction du panneau 1 dans l'espace d'emboîtement.

Les figures 10a et 10b présente deux vues en perspective d'une variante du sixième mode de réalisation selon l'invention. La talonnette 3 est collée sur la partie périphérique du panneau 1 et forme une cornière en U. L'agrafe 15 est griffée sur la talonnette 3 grâce à des languettes 14", en chaque extrémité de l'agrafe 15 dans le sens de la longueur (une seule languette 14", coopérant avec la talonnette 3, est visible sur les figures 10a et 10b du fait de la présence du clip 5" qui masque une autre languette 14" à l'autre extrémité). La talonnette 3 et l'agrafe 15 ont sensiblement la même longueur. Le clip 5" a une longueur inférieure et enserre l'agrafe 15, la talonnette 3 et la partie périphérique du panneau 1. Il est fixé grâce à une languette 14" de l'agrafe 15, venant se bloquer sur un épaulement ménagé sur les parois internes du clip 5", visible sur les figures 10a et 10b. Le dispositif de fixation 2 assure une fonction anti-retour (dans le sens de l'extraction du panneau 1) et une tenue mécanique performante.

Le panneau 1 présentant une surface périphérique 4 munie de dispositifs de fixation 2 pivotants selon l'invention peut en particulier constituer un module photovoltaïque comportant une pluralité de cellules photovoltaïques.

Avantageusement, le panneau 1 est un module photovoltaïque bi-verre sans cadre. Le panneau 1 pourra également être un module photovoltaïque biface sans cadre, c'est-à-dire comportant une pluralité de cellules photovoltaïques sur chacune de ses deux faces principales. Chaque dispositif de fixation 2 occupe une surface périphérique du panneau 1 comprise dans une zone dite morte, c'est-à-dire dépourvue de cellules photovoltaïques. Cette zone morte a typiquement une largeur de 15mm. La pluralité de dispositifs de fixation 2 dont est muni le panneau 1 ne crée ainsi pas d'ombrage susceptible d'affecter la performance des cellules photovoltaïques.

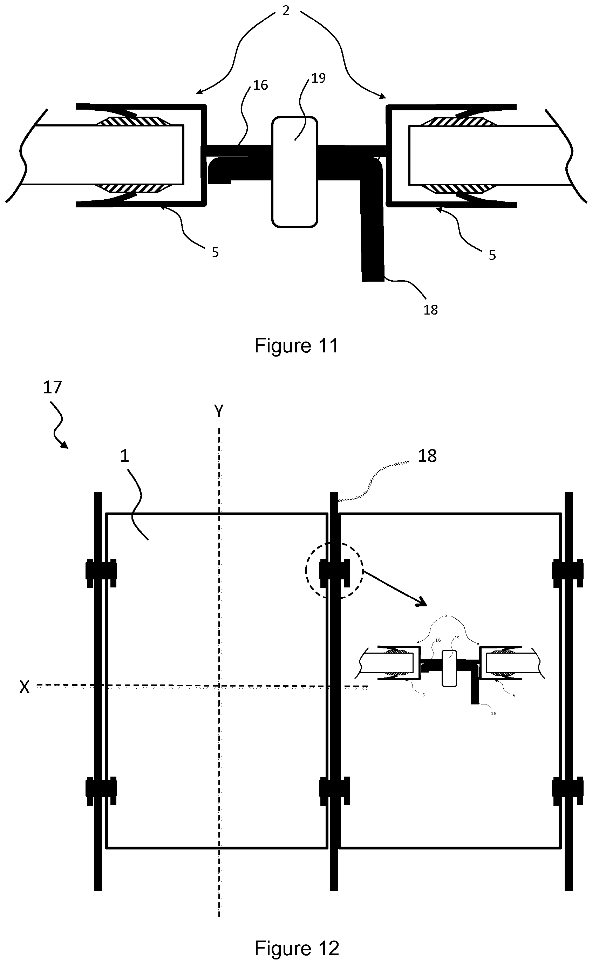

Comme représenté sur la figure 11, un tel module doit être assemblé sur les rails 18 d'une structure porteuse. Chaque dispositif de fixation 2 comporte un élément support 16 solidaire du clip 5. L'élément support 16 est destiné à être solidarisé au rail 18, au moyen d'un moyen de fixation 19. Ce moyen de fixation 19 pourra par exemple être un clip de fixation.

La figure 12 montre un assemblage 17 de deux panneaux 1, chaque panneau 1 étant muni de quatre dispositifs de fixation disposés sur des parties périphériques de ses grands côtés (selon l'axe Y schématisé sur la figure). Avantageusement les dispositifs de fixation sont disposés à des emplacements correspondant environ à un quart et à trois quarts de la longueur du panneau 1 (selon l'axe Y). Une telle configuration favorise la planéité du panneau 1 selon l'axe Y, sous une charge pondérale uniforme.

Les dispositifs de fixation précédemment décrits dans les différents modes de réalisation de l'invention autorisent des degrés de liberté de mouvement du panneau 1, notamment en pivotement. Ainsi, sous charge pondérale, le fléchissement du panneau 1 selon l'axe X schématisé sur la figure 12 ne génère pas de point de concentration de contraintes car il n'y a pas de contact plan entre le panneau 1 fléchissant et le clip 5 fixé sur le rail 18. Par ailleurs, la flexibilité de la liaison talonnette/clip autorise également un léger pivotement du panneau 1 dans le clip lors de son éventuelle flexion le long de l'axe Y.

Il est néanmoins important que le mouvement de translation de chaque panneau 1 selon l'axe Y (c'est-à-dire selon une direction perpendiculaire à l'axe d'emboîtement et parallèle aux faces principales du panneau 1) soit bloqué. En effet, dans le cas particulier des modules photovoltaïques sans cadre, le contact et le frottement entre les bords de deux panneaux voisins endommageraient ceux-ci. Les dispositifs de fixation selon l'invention répondent à cette spécification en intégrant ce blocage en translation, ne nécessitant donc pas l'adjonction d'un élément de butée externe.

Dans le cas d'un dispositif de fixation basé sur une fixation par griffure d'une languette (le matériau constitutif de la languette étant plus dur que le matériau constitutif de l'élément griffé, talonnette ou clip), un bourrelet se forme pour bloquer la languette, dans le sens de l'extraction du panneau 1 (selon l'axe d'emboîtement). Un bourrelet se forme également au niveau de chaque coin des languettes : il constitue une butée qui bloque le mouvement de translation du panneau 1 selon l'axe Y schématisé sur la figure 12.

Dans le cas d'une fixation par blocage d'une languette sur un épaulement (comme décrit dans le premier mode de réalisation), un épaulement bloquant le mouvement en translation selon l'axe Y de la languette est ajouté sur l'élément coopérant avec celle-ci (talonnette et/ou clip).

Bien entendu, l'invention n'est pas limitée aux modes de mise en œuvre décrits et on peut y apporter des variantes de réalisation sans sortir du cadre de l'invention tel que défini par les revendications.

## Revendications

1. Panneau (1) susceptible de fléchir sous l'effet d'une charge et présentant une surface périphérique munie d'une pluralité de dispositifs de fixation (2) pivotants, **caractérisé en ce que** chaque dispositif de fixation (2) comprend :
• une talonnette (3,3',3") métallique collée sur la surface périphérique (4) du panneau (1) ;
• un clip (5,5',5") métallique coopérant par emboîtement avec la talonnette (3,3',3") et configuré pour autoriser le pivotement de la talonnette (3,3',3") lors du fléchissement du panneau (1) ;
• au moins une languette (14, 14') de fixation flexible, située entre la talonnette (3,3',3") et le clip (5,5',5") dans un espace d'emboitement (8), et permettant de maintenir la talonnette (3,3',3") et le clip (5,5',5") l'un par rapport à l'autre ;
et dans lequel :
• le clip (5,5") comprend deux parois (6,7;6",7") en vis-à-vis définissant l'espace d'emboîtement (8) permettant d'introduire la talonnette (3,3") dans le clip (5,5") selon un axe d'emboîtement (A), ou
• la talonnette (3') comprend deux parois (6', 7') en vis-à-vis définissant l'espace d'emboîtement (8') permettant d'introduire le clip (5') dans la talonnette (3') selon un axe d'emboîtement (A').

2. Panneau (1) selon la revendication précédente, dans lequel l'espace d'emboîtement (8,8') est suffisant pour dégager un espace libre entre la talonnette (3,3',3") et le clip (5,5',5"), autorisant le pivotement de l'un par rapport à l'autre lors du fléchissement du panneau (1).

3. Panneau (1) selon la revendication précédente dans lequel chaque dispositif de fixation (2) est configuré pour permettre un mouvement de translation limité de la talonnette (3,3',3") selon l'axe d'emboîtement (A,A') lors du fléchissement du panneau (1).

4. Panneau (1) selon l'une des revendications précédentes, dans lequel le panneau (1) présente deux faces principales (9,10) et un bord (11) reliant les deux faces principales (9,10), et dans lequel la surface périphérique (4) s'étend sur une partie périphérique de chacune des faces principales (9,10) et sur le bord (11).

5. Panneau (1) selon la revendication précédente, dans lequel chaque dispositif de fixation (2) comprend une butée bloquant le mouvement en translation de la talonnette (3,3',3"), selon une direction perpendiculaire à l'axe d'emboîtement (A, A') et parallèle aux faces principales (9,10) du panneau (1).

6. Panneau (1) selon la revendication précédente, dans lequel la talonnette (3,3',3") comprend une première partie (31,31',31") collée sur une des faces principales (9).

7. Panneau (1) selon la revendication précédente, dans lequel la talonnette (3,3',3") comprend une deuxième partie (32,32',32") collée sur l'autre des faces principales (10) .

8. Panneau (1) selon la revendication précédente, dans lequel la talonnette (3,3',3") comprend une troisième partie (33,33',33") collée sur le bord (11), formant avec les première (31,31',31") et deuxième (32,32',32") parties une cornière en U.

9. Panneau (1) selon l'une des revendications précédentes, dans lequel la talonnette (3,3',3") comporte une partie déportée (12, 12') présentant deux faces opposées et libres sur lesquelles le clip (5,5',5") est fixé.

10. Panneau (1) selon l'une des revendications précédentes, dans lequel le dispositif de fixation (2) comprend un corps d'appui (13) linéaire contribuant à autoriser le pivotement de la talonnette (3,3',3") lors du fléchissement du panneau (1).

11. Panneau (1) selon l'une des revendications précédentes, dans lequel le clip (5,5') porte au moins une languette de fixation (14,14') formée par découpe et pliage, griffée sur la talonnette (3).

12. Panneau (1) selon la revendication précédente, dans lequel la dureté du matériau constituant le clip (5,5') est supérieure à celle du matériau constituant la talonnette (3,3'), de manière à assurer le maintien du panneau (1) par griffure de la languette de fixation (14,14') sur la talonnette (3,3').

13. Panneau (1) selon l'une des revendications 1 à 10, dans lequel la talonnette (3") porte au moins une languette de fixation (14") formée par découpe et pliage, griffée sur le clip (5").

14. Panneau selon la revendication précédente, dans lequel la dureté du matériau constituant la talonnette (3") est supérieure à celle du matériau constituant le clip (5"), de manière à assurer le maintien du panneau (1) par griffure de la languette de fixation (14") sur le clip (5'').

15. Panneau (1) selon l'une des revendications 1 à 10, dans lequel chaque dispositif de fixation (2) comprend au moins une agrafe (15) positionnée dans l'espace d'emboîtement (8) entre la talonnette (3) et le clip (5"), l'agrafe (15) portant une pluralité de languettes de fixation (14") formées par découpe et pliage.

16. Panneau (1) selon la revendication précédente, dans lequel la dureté du matériau constituant l'agrafe (15) est supérieure à celle des matériaux constituant le clip (5") et la talonnette (3), de manière à assurer le maintien du panneau (1) par griffure des languettes de fixation (14") sur le clip (5") et sur la talonnette (3).

17. Panneau (1) selon l'une des revendications précédentes, dans lequel le panneau (1) constitue un module photovoltaïque comportant une pluralité de cellules photovoltaïques.

18. Panneau (1) selon la revendication précédente, dans lequel la partie périphérique des faces principales (9,10) du panneau (1) est une zone dite morte, dépourvue de cellules photovoltaïques.

19. Panneau (1) selon l'une des deux revendications précédentes, dans lequel le module photovoltaïque est un module photovoltaïque bi-verre sans cadre.

20. Panneau (1) selon l'une des trois revendications précédentes, dans lequel le module photovoltaïque est un module photovoltaïque biface sans cadre.

21. Panneau (1) selon l'une des revendications précédentes, dans lequel chaque dispositif de fixation (2) comporte un élément support (16) solidaire du clip (5,5',5") pour assembler le panneau (1) sur une structure porteuse.

22. Assemblage (17) de panneaux comportant :
• une structure porteuse présentant des rails de maintien (18)
• une pluralité de panneaux (1) selon la revendication précédente reposant sur les rails (18) par l'intermédiaire des éléments supports (16) ;
• des moyens de fixation (19) pour assembler les éléments supports (16) sur les rails (18).

## Patentansprüche

1. Platte (1), die sich unter der Wirkung einer Last biegen kann und eine Umfangsfläche aufweist, die mit mehreren schwenkbaren Befestigungsvorrichtungen (2) versehen ist, **dadurch gekennzeichnet, dass** jede Befestigungsvorrichtung (2) umfasst:
• einen kleinen Metallansatz (3, 3', 3"), der an die Umfangsfläche (4) der Platte (1) geklebt ist;
• eine Metallklammer (5, 5', 5"), die durch Ineinandergreifen mit dem kleinen Ansatz (3, 3', 3") zusammenwirkt und so konfiguriert ist, dass der kleine Ansatz (3, 3', 3") schwenken kann, wenn die Platte (1) gebogen wird;
• mindestens eine flexible Befestigungslasche (14, 14'), die sich zwischen dem kleinen Ansatz (3, 3', 3") und der Klammer (5, 5', 5") in einem Eingriffsraum (8) befindet und es zulässt, den kleinen Ansatz (3, 3', 3") und die Klammer (5, 5', 5") relativ zueinander zu halten;
und wobei:
• die Klammer (5, 5") zwei einander gegenüberliegende Wände (6, 7; 6", 7") umfasst, die den Eingriffsraum (8) definieren und das Einführen des kleinen Ansatzes (3, 3") in die Klammer (5, 5") entlang einer Eingriffsachse (A) zulassen, oder
• der kleine Ansatz (3') zwei gegenüberliegende Wände (6', 7') umfasst, die den Eingriffsraum (8') definieren und das Einführen der Klammer (5') in den kleinen Ansatz (3') entlang einer Eingriffsachse (A') zulassen.

2. Platte (1) nach dem vorhergehenden Anspruch, wobei der Eingriffsraum (8, 8') ausreicht, um einen Freiraum zwischen dem kleinen Ansatz (3, 3', 3") und der Klammer (5, 5', 5") freizugeben, der das Schwenken des einen relativ zum anderen zulässt, wenn die Platte (1) gebogen wird.

3. Platte (1) nach dem vorhergehenden Anspruch, wobei jede Befestigungsvorrichtung (2) so konfiguriert ist, dass sie eine begrenzte Translationsbewegung des kleinen Ansatzes (3, 3', 3") entlang der Eingriffsachse (A, A') zulässt, wenn die Platte (1) gebogen wird.

4. Platte (1) nach einem der vorhergehenden Ansprüche, wobei die Platte (1) zwei Hauptflächen (9, 10) und eine Kante (11) aufweist, die die beiden Hauptflächen (9, 10) verbindet, und wobei sich die Umfangsfläche (4) über einen Umfangsabschnitt jeder der Hauptflächen (9, 10) und die Kante (11) erstreckt.

5. Platte (1) nach dem vorhergehenden Anspruch, wobei jede Befestigungsvorrichtung (2) einen Anschlag umfasst, der die Translationsbewegung des kleinen Ansatzes (3, 3', 3") in einer Richtung senkrecht zur Eingriffsachse (A, A') und parallel zu den Hauptflächen (9, 10) der Platte (1) blockiert.

6. Platte (1) nach dem vorhergehenden Anspruch, wobei der kleine Ansatz (3, 3', 3") einen ersten Abschnitt (31, 31', 31") umfasst, der an eine der Hauptflächen (9) geklebt ist.

7. Platte (1) nach dem vorhergehenden Anspruch, wobei der kleine Ansatz (3, 3', 3") einen zweiten Abschnitt (32, 32', 32") umfasst, der an die andere der Hauptflächen (10) geklebt ist.

8. Platte (1) nach dem vorhergehenden Anspruch, wobei der kleine Ansatz (3, 3', 3") einen dritten Abschnitt (33, 33', 33") umfasst, der an die Kante (11) geklebt ist und mit dem ersten (31, 31', 31") und dem zweiten (32, 32', 32") Abschnitt einen U-förmigen Winkel bildet.

9. Platte (1) nach einem der vorhergehenden Ansprüche, wobei der kleine Ansatz (3, 3', 3") einen versetzten Abschnitt (12, 12') mit zwei gegenüberliegenden Freiflächen umfasst, an denen die Klammer (5, 5', 5") befestigt ist.

10. Platte (1) nach einem der vorhergehenden Ansprüche, wobei die Befestigungsvorrichtung (2) einen linearen Stützkörper (13) umfasst, der dazu beiträgt, das Schwenken des kleinen Ansatzes (3, 3', 3") zuzulassen, wenn die Platte (1) gebogen wird.

11. Platte (1) nach einem der vorhergehenden Ansprüche, wobei die Klammer (5, 5') mindestens eine durch Schneiden und Falten gebildete Befestigungslasche (14, 14') trägt, die am kleinen Ansatz (3) angelascht ist.

12. Platte (1) nach dem vorhergehenden Anspruch, wobei die Härte des Materials, aus dem die Klammer (5, 5') besteht, größer ist als die des Materials, aus dem der kleine Ansatz (3, 3') besteht, so dass das Halten der Platte (1) durch Anlaschen der Befestigungslasche (14, 14') auf dem kleinen Ansatz (3, 3') gewährleistet ist.

13. Platte (1) nach einem der Ansprüche 1 bis 10, wobei der kleine Ansatz (3") mindestens eine durch Schneiden und Falten gebildete Befestigungslasche (14") trägt, die auf der Klammer (5") angelascht ist.

14. Platte nach dem vorhergehenden Anspruch, wobei die Härte des Materials, aus dem der kleine Ansatz (3") besteht, größer ist als die des Materials, aus dem die Klammer (5") besteht, so dass das Halten der Platte (1) durch Anlaschen der Befestigungslasche (14") auf der Klammer (5") gewährleistet ist.

15. Platte (1) nach einem der Ansprüche 1 bis 10, wobei jede Befestigungsvorrichtung (2) mindestens eine Klemme (15) umfasst, die in dem Eingriffsraum (8) zwischen dem kleinen Ansatz (3) und der Klammer (5") positioniert ist, wobei die Klemme (15) mehrere durch Schneiden und Falten gebildete Befestigungslaschen (14") trägt.

16. Platte (1) nach dem vorhergehenden Anspruch, wobei die Härte des Materials, aus dem die Klemme (15) besteht, größer ist als die der Materialien, aus denen die Klammer (5") und der kleine Ansatz (3) bestehen, so dass das Halten der Platte (1) durch Anlaschen der Befestigungslaschen (14") auf der Klammer (5") und dem kleinen Ansatz (3) gewährleistet ist.

17. Platte (1) nach einem der vorhergehenden Ansprüche, wobei die Platte (1) ein Photovoltaikmodul bildet, das eine Vielzahl von Photovoltaikzellen umfasst.

18. Platte (1) nach dem vorhergehenden Anspruch, wobei der Umfangsabschnitt der Hauptflächen (9, 10) der Platte (1) eine sogenannte Totzone ohne Photovoltaikzellen ist.

19. Platte (1) nach einem der beiden vorhergehenden Ansprüche, wobei das Photovoltaikmodul ein rahmenloses Zwei-Glas-Photovoltaikmodul ist.

20. Platte (1) nach einem der drei vorhergehenden Ansprüche, wobei das Photovoltaikmodul ein rahmenloses zweiseitiges Photovoltaikmodul ist.

21. Platte (1) nach einem der vorhergehenden Ansprüche, wobei jede Befestigungsvorrichtung (2) ein Stützelement (16) umfasst, das mit der Klammer (5, 5', 5") fest verbunden ist, um die Platte (1) auf einer Tragstruktur zu montieren.

22. Plattenanordnung (17), umfassend:
• eine Tragstruktur mit Halteschienen (18)
• eine Vielzahl von Platten (1) nach dem vorhergehenden Anspruch, die über Stützelemente (16) auf den Schienen (18) aufliegen;
• Befestigungsmittel (19) zum Montieren der Stützelemente (16) auf den Schienen (18).

## Claims

1. Panel (1) capable of bending under the effect of a load and having a peripheral surface provided with a plurality of pivoting attachment devices (2), **characterized in that** each attachment device (2) comprises:
• a metal gripping member (3, 3', 3") adhered to the peripheral surface (4) of the panel (1);
• a metal clip (5, 5', 5") cooperating by interlocking with the gripping member (3, 3', 3") and configured to allow the gripping member (3, 3', 3") to pivot when the panel (1) bends;
• at least one flexible attachment tab (14, 14') located between the gripping member (3, 3', 3") and the clip (5, 5', 5") in an interlocking space (8), and allowing the gripping member (3, 3', 3") and the clip (5, 5', 5") to be retained relative to each other;
and:
• the clip (5, 5") comprising two mutually facing walls (6, 7; 6", 7") defining the interlocking space (8), allowing the gripping member (3, 3") to be inserted into the clip (5, 5") along an interlocking axis (A); or
• the gripping member (3') comprising two mutually facing walls (6', 7') defining the interlocking space (8'), allowing the clip (5') to be inserted into the gripping member (3') along an interlocking axis (A').

2. Panel (1) according to the preceding claim, wherein the interlocking space (8, 8') is sufficient to provide a free space between the gripping member (3, 3', 3") and the clip (5, 5', 5"), allowing the gripping member and the clip to pivot relative to each other when the panel (1) bends.

3. Panel (1) according to the preceding claim, wherein each attachment device (2) is configured to allow limited translational movement of the gripping member (3, 3', 3") along the interlocking axis (A, A') when the panel (1) bends.

4. Panel (1) according to any of the preceding claims, wherein the panel (1) has two main sides (9, 10) and an edge (11) connecting the two main sides (9, 10), and wherein the peripheral surface (4) extends across a peripheral portion of each of the main sides (9, 10) and across the edge (11).

5. Panel (1) according to the preceding claim, wherein each attachment device (2) comprises a stop blocking the translational movement of the gripping member (3, 3', 3"), in a direction perpendicular to the interlocking axis (A, A') and parallel to the main sides (9, 10) of the panel (1).

6. Panel (1) according to the preceding claim, wherein the gripping member (3, 3', 3") comprises a first portion (31, 31', 31") adhered to one of the main sides (9).

7. Panel (1) according to the preceding claim, wherein the gripping member (3, 3', 3") comprises a second portion (32, 32', 32") adhered to the other of the main sides (10).

8. Panel (1) according to the preceding claim, wherein the gripping member (3, 3', 3") comprises a third portion (33, 33', 33") adhered to the edge (11), forming a U-shaped angle together with the first portion (31, 31', 31") and second portion (32, 32', 32").

9. Panel (1) according to any of the preceding claims, wherein the gripping member (3, 3', 3") has an offset portion (12, 12') having two opposite and free sides on which the clip (5, 5', 5") is fixed.

10. Panel (1) according to any of the preceding claims, wherein the attachment device (2) comprises a linear support body (13) helping to allow the gripping member (3, 3', 3") to pivot when the panel (1) bends.

11. Panel (1) according to any of the preceding claims, wherein the clip (5, 5') carries at least one attachment tab (14, 14') formed by cutting and folding, clamped on the gripping member (3).

12. Panel (1) according to the preceding claim, wherein the hardness of the material constituting the clip (5, 5') is greater than that of the material constituting the gripping member (3, 3'), so as to ensure that the panel (1) is retained by clamping the attachment tab (14, 14') on the gripping member (3, 3').

13. Panel (1) according to any of claims 1 to 10, wherein the gripping member (3") carries at least one attachment tab (14") formed by cutting and folding, clamped on the clip (5").

14. Panel according to the preceding claim, wherein the hardness of the material constituting the gripping member (3") is greater than that of the material constituting the clip (5"), so as to ensure that the panel (1) is retained by clamping the attachment tab (14") on the clip (5").

15. Panel (1) according to any of claims 1 to 10, wherein each attachment device (2) comprises at least one hook (15) positioned in the interlocking space (8) between the gripping member (3) and the clip (5"), the hook (15) carrying a plurality of attachment tabs (14") formed by cutting and folding.

16. Panel (1) according to the preceding claim, wherein the hardness of the material constituting the hook (15) is greater than that of the materials constituting the clip (5") and the gripping member (3), so as to ensure that the panel (1) is retained by clamping the attachment tabs (14") on the clip (5") and the gripping member (3).

17. Panel (1) according to any of the preceding claims, wherein the panel (1) constitutes a photovoltaic module comprising a plurality of photovoltaic cells.

18. Panel (1) according to the preceding claim, wherein the peripheral portion of the main sides (9, 10) of the panel (1) is a so-called dead zone, free of photovoltaic cells.

19. Panel (1) according to either of the two preceding claims, wherein the photovoltaic module is a frameless two-glass photovoltaic module.

20. Panel (1) according to any of the three preceding claims, wherein the photovoltaic module is a frameless two-sided photovoltaic module.

21. Panel (1) according to any of the preceding claims, wherein each attachment device (2) comprises a support element (16) integral with the clip (5, 5', 5") for assembling the panel (1) on a support structure.

22. Panel assembly (17) comprising:
• a support structure having retaining rails (18);
• a plurality of panels (1) according to the preceding claim resting on the rails (18) via the support elements (16);
• attachment means (19) for assembling the support elements (16) on the rails (18).
